(19) **Europäisches Patentamt**

**European Patent Office**

**Office européen des brevets**

(11) **EP 0 578 008 B1**

(12) **EUROPÄISCHE PATENTSCHRIFT**

(45) Veröffentlichungstag und Bekanntmachung des Hinweises auf die Patenterteilung:
**15.03.2000 Patentblatt 2000/11**

(51) Int. Cl.[7]: **H03G 3/32**, H03G 5/16

(21) Anmeldenummer: **93109502.0**

(22) Anmeldetag: **15.06.1993**

(54) **Verfahren zur Verdeckung des Fahrgeräusches**

Vehicular radio receiver with speed compensated tone control

Dispositif de compensation la volume sonore d'une auto-radio en fonction de la vitesse du véhicule

(84) Benannte Vertragsstaaten:
**DE ES FR GB IT**

(30) Priorität: **04.07.1992 DE 4221998**

(43) Veröffentlichungstag der Anmeldung:
**12.01.1994 Patentblatt 1994/02**

(73) Patentinhaber:
**Blaupunkt-Werke GmbH**
**31132 Hildesheim (DE)**

(72) Erfinder: **Kässer, Jürgen, Dr.**
**D-3201 Diekholzen (DE)**

(56) Entgegenhaltungen:
**EP-A- 0 307 725**       **EP-A- 0 332 079**
**EP-A- 0 528 475**       **DE-A- 3 910 724**
**GB-A- 1 518 574**       **US-A- 5 046 107**

**Beschreibung**

Gegenstand des Schutzrechts ist ein neues Verfahren zur Verdeckung des Fahrgeräusches in Kraftfahrzeugen bei der Wiedergabe von elektrischen Signalen über Lautsprecher.

Aus der DE 37 30 763 C2 ist eine Schaltung zur Störgeräuschkompensation bekannt, in der die Lautsprecher über einen Equalizer angesteuert werden, der das Nutzsignal in verschiedenen Frequenzbändern getrennt voneinander beeinflußt. Diese bekannte Schaltung setzt die Verwendung eines Mikrophons innerhalb der Fahrgastzelle des Kraftfahrzeugs zur Aufnahme des Störgeräusches voraus.

Ebenso ist aus der GB-A-1518574 eine Anordnung zur störgeräuschabhängigen Beeinflussung eines in einem Kraftfahrzeug wiedergegebenen Audiosignals bekannt, bei der das Audiosignal in verschiedenen Frequenzbändern in Abhängigkeit des Störgeräuschpegels in dem jeweiligen Frequenzband getrennt verstärkt wird. Alternativ zur Erfassung des Störgeräusches mittels eines Mikrophons kann zur Ermittlung des Störgeräuschpegels auch die Fahrzeuggeschwindigkeit herangezogen werden.

Bei anderen Verfahren werden Lautstärkenregler in Abhängigkeit von der Fahrgeschwindigkeit eingestellt.

Schließlich ist aus der US-A-5046107 eine Schaltungsanordnung zur Anpassung des Eingangspegels für einen Eingangsquellenumschalter zum Anschluß verschiedener Quellen bekannt, bei der neben einem Umschaltsignal zur Auswahl einer Quelle an eine im Signalpfad angeordnete Pegelanpassung ein einer jeden einzustellenden Quelle zugeordneter Verstärkungsfaktor abgegeben wird.

Der Erfindung lag die Aufgabe zugrunde, die Störgeräuschverdeckung weiter zu verbessern.

Die Lösung dieser Aufgabe ist durch die Merkmale der Ansprüche 1 und 2 gekennzeichnet.

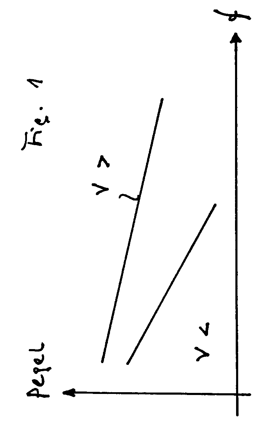

Bei gleichbleibender Oberfläche einer in freier Landschaft verlaufenden Fahrbahn läßt sich das in der Fahrgastzelle wahrgenommene Geräusch etwa durch die in Figur 1 dargestellten Kurvenverläufe wiedergeben.

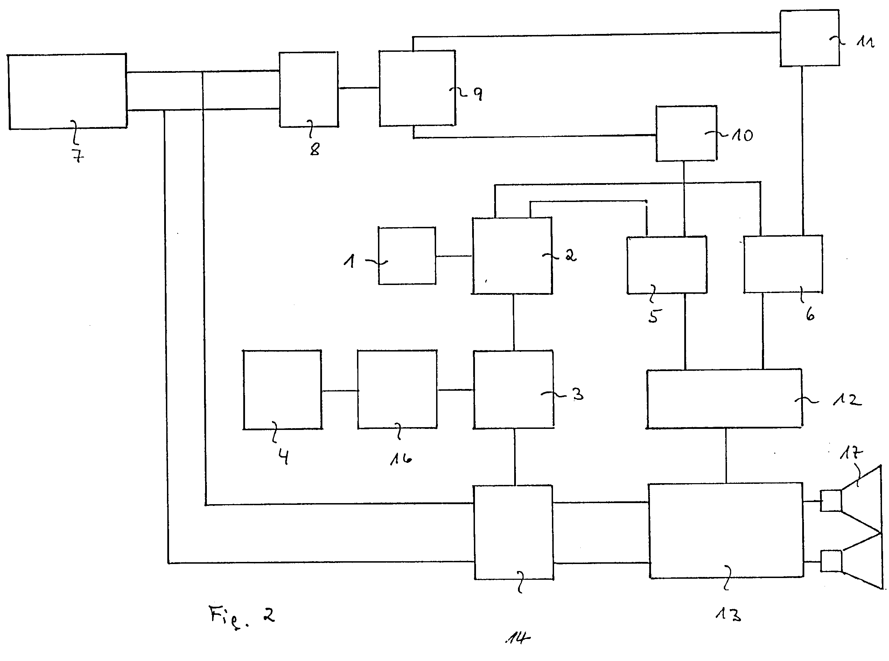

Ein Blockschaltbild einer erfindungsgemäß arbeitenden elektronischen Anlage zur Verdeckung dieses Fahrzeuggeräusches ist in Figur 2 dargestellt.

Nach Figur 1 ist bei kleiner Fahrgeschwindigkeit der Fahrlärm in der Fahrgastzelle bei tiefen Frequenzen bedeutend höher als bei mittleren Frequenzen. In höheren Frequenzbereichen ist das Geräusch in der Fahrgastzelle vernachlässigbar. Bei größerer Geschwindigkeit nimmt der Fahrlärm in allen Frequenzbereichen erheblich zu und wird auch in höheren Frequenzbereichen deutlich wahrnehmbar.

Die Erfindung ging von dem Gedanken aus, die Erkenntnisse über diese geschwindigkeitsabhängige Geräuschwahrnehmung in der Fahrgastzelle zur Steuerung eines Equalizers auszunutzen und ein nach diesen Erkenntnissen ausgelegtes Rechenwerk nach individueller Eichung anstelle des Innenraummikrophones zu verwenden.

In der in Figur 2 dargestellten Schaltung, die nach dem erfindungsgemäßen Verfahren arbeitet, liefert ein Geschwindigkeitssensor 1 einen geschwindigkeitsabhängigen Stellwert für ein Rechenwerk 2. Dieses Rechenwerk 2 hat einen zweiten Steuereingang, einen Eicheingang, der die Stellwerte eines Verstärkers 3 im Ausgang eines Rauschgenerators 4 übernimmt. Das Rechenwerk 2 liefert je einen Wert für zwei Korrelatoren 5 und 6, die ihren zweiten Wert vom Stereodecoder eines nicht näher dargestellten Rundfunkempfängers 7 erhalten. Dazu sind die beiden Stereosignalausgänge in einem Addierer 8 zusammengefaßt und dann in einer zweiten Frequenzweiche 9 mit Filterwirkung durch zwei Bandbegrenzer in zwei Frequenzbänder aufgespalten, die deutlich getrennt voneinander liegen. Die Hüllkurve der Signale in jedem Frequenzband werden in den Demodulatoren 10 und 11 ermittelt. Diese Pegelwerte werden dann den Quotientenbildnern 5 und 6 als zweiter Wert zugeführt.

Beide Quotientenbildner liefern Stellsignale für die Einsteller 12 eines Equalizers 13, z. B. eines aus den Unterlagen des bereits genannten DBP 37 30 763 bekannten Equalizers.

Die Einstellung der Frequenzbereiche außerhalb der beschriebenen beiden Bänder erfolgt proportional zu den in den Testbändern ermittelten Werten.

Die beiden Signaleingänge dieses Equalizers 13 sind über einen ersten Umschalter 14 wahlweise mit den Ausgängen des Stereodecoders im Rundfunkempfänger 7 oder aber mit dem Ausgang des von Hand regelbaren Verstärkers 3 verbunden. Dieser Verstärker 3 ist über einen zweiten Umschalter 15 einer ersten Frequenzweiche 16 nachgeschaltet, die entsprechend der zweiten Frequenzweiche 9 aufgebaut ist und zwei Bandbegrenzer umfaßt. Der Baustein 16 wird seinerseits von dem Rauschgenerator 4 gespeist.

In dieser Schaltung erfolgt eine Vierpunkt-Eichung des Rechenwerkes 2 auf folgende Weise:

Die beiden Frequenzbänder in den Bausteinen 9 und 16 haben eine Mittenfrequenz von etwa 200 Hz bzw. 1 000 Hz. Bei einer Fahrt des Fahrzeugs mit etwa 50 km/Stunde werden durch die Umschalter 14 und 15 die Signale des Rauschgenerators 4 auf den Eingang des Equalizers 13 gegeben und dabei der Verstärker 3 derart eingestellt, daß die Signale aus dem Lautsprecher 17 etwa gleichlaut wie das Fahrgeräusch empfunden werden, und zwar in beiden Frequenzbändern getrennt. Die gleiche Einstellung wird bei einer Fahrgeschwindigkeit von 100 km/Stunde wiederholt. Damit liegen je zwei Punkte für jede der in Figur 1 dargestellten proportionalen Abhängigkeiten zwischen der Lautstärke und der Frequenz von der Geschwindigkeit fest. Diese Einstellungen werden im Rechenwerk 2 gespeichert.

Danach ist der Fahrgeräuschpegel, der in den verschiedenen Frequenzbereichen $f_i$ von der Geschwindigkeit $v_i$ abhängig ist, in bestimmten Frequenzbereichen bei vorgegebenen Geschwindigkeiten gleich dem im Fahrzeug über den Rauschgenerator erzeugten Rauschpegel $R_{ij}$.

Die in Figur 1 gezeigte Abhängigkeit läßt sich mathematisch darstellen als

$$F(f, v) = a(v) + b(v). f$$

$$a(v) = a_0 + a_1 . v, \quad b(v) = b_0 + b_1 v$$

$F$ = Fahrgeräusch, $f$ = Frequenz, $v$ = Geschwindigkeit,
$a_0, a_1, b_0, b_1$ = fahrzeugspezifische Konstanten
Bei

$f_1 = 200$ Hz und $v_1 = 50$ km/Std., $v_2 = 100$ km/Std. sowie
$f_2 = 1\ 000$ Hz und $v_1 = 50$ km/Std., $v_2 = 100$ km/Std.
ist

$$F(f_1, v_1) = R_{11}$$
$$F(f_1, v_2) = R_{12}$$
$$F(f_2, v_1) = R_{21}$$
$$F(f_2, v_2) = R_{22}$$

Mit diesen Größen lassen sich die fahrzeugspezifischen Konstanten $a_0 ... b_1$ in der Beziehung zwischen Fahrgeräusch und Geschwindigkeit in den betrachteten Frequenzbändern berechnen. Es gilt

$$F_{f1}(v) = a_0 + b_0 f_1 + (a_1 + b_2 . f_1) . v = \alpha_1 + \beta_1 . v$$

$$F_{f2}(v) = a_0 + b_0 f_2 + (a_1 + b_1 f_2) . v = \alpha_2 + \beta_2 . v,$$

wobei die Konstanten $\alpha_1 ... \beta_2$ eindeutig durch $f_1, f_2, v_1, v_2, R_{11} ... R_{22}$ beschrieben werden. Ihre Berechnung erfolgt einmalig während des Eichvorganges. Während des Betriebs wird mit diesen Konstanten laufend in Abhängigkeit von der Geschwindigkeit des Fahrgeräusches errechnet.

Diese Berechnung erfolgt im Rechenwerk 2, an dessen Ausgängen je nach der vom Sensor 1 festgestellten Geschwindigkeit jeweils bestimmte Ausgangswerte abgreifbar sind. Diese Rechenwerte bilden dann einen Eingangswert für den jeweiligen Quotientenbildner 5 bzw. 6.

Der zweite Eingangswert für die Quotientenbildner 5 und 6 liefern - wie bereits erwähnt - die Demodulatoren 10, 11 in den entsprechenden Frequenzbändern.

## Patentansprüche

1.   Verfahren zur Fahrgeräuschverdeckung in Kraftfahrzeugen bei der Wiedergabe von elektrischen Nutzsignalen über Lautsprecher, wobei die Pegel des Nutzsignals in verschiedenen Frequenzbändern getrennt einstellbar sind, dadurch gekennzeichnet, daß die wiederzugebenden Signale in Korrelatoren (5, 6) mit frequenzbandspezifischen Bezugsgrößen zur Bildung von Stellsignalen zur Einstellung der Nutzsignalpegel verknüpft werden, und daß die Einstellung der Nutzsignalpegel entsprechend dem Verhältnis des wiederzugebenden Signals in einzelnen Frequenzbändern zu frequenzbandspezifischen Bezugsgrößen erfolgt, und die frequenzbandspezifischen Bezugsgrößen aus der Momentangeschwindigkeit des Fahrzeuges hergeleitet werden.

2.   Schaltung zur Fahrgeräuschverdeckung gemäß dem Verfahren nach Anspruch 1 mit einem Rechenwerk (2) zur Bildung frequenzbandspezifischer Bezugsgrößen aus einem die Momentangeschwindigkeit des Fahrzeuges anzeigenden Signal, mit einem den Lautsprechern (17) vorgeschalteten Equalizer (13), dessen Signaleingänge über einen ersten Umschalter (14) wahlweise mit dem Ausgang eines Rundfunkempfängers (7) und zur Eichung eines Rechenwerkes (2) über einen Verstärker (3) zur Einstellung des Equalizers (13) mit dem Ausgang eines Rauschsignalgenerators (4) verbindbar sind, mit einer ersten Frequenzweiche (16) im Ausgang des Rauschsignalgenerators (4), deren Ausgänge über einen zweiten Umschalter (15) an den Verstärker anschließbar sind, dessen Einstellwerte in dem Rechenwerk (2) gespeichert und mit dem Meßwert eines Geschwindigkeitssensors (1) korreliert werden, und mit einer zweiten Frequenzweiche (9) im Ausgang des Rundfunkempfängers (7), welcher Korrelatoren (5, 6) nachgeschaltet sind, in denen die Ausgangssignale der zweiten Frequenzweiche mit Bewertungsgrößen aus dem Rechenwerk (2) zur Einstellung des Equalizers (13) korreliert werden.

3. Schaltung nach Anspruch 2, gekennzeichnet durch einen Speicher, in dem Koeffizienten, die den funktionalen Zusammenhang zwischen Geschwindigkeit und Fahrgeräusch in den einzelnen Bändern charakterisieren, abgelegt sind.

4. Schaltung nach Anspruch 2, dadurch gekennzeichnet, daß der Korrelator (5, 6) jeweils den Quotienten zwischen der Hüllkurve der Ausgangssignale der zweiten Frequenzweiche (9) und der Ausgangssignale des Rechenwerkes (2) bildet.

5. Schaltung nach Anspruch 2 oder 3, dadurch gekennzeichnet, daß ein Stereodecoder den Ausgang des Rundfunkempfängers (7) bildet und im Eingang der zweiten Frequenzweiche (9) ein Addierer (8) für beide Sterosignale angeordnet ist.

**Claims**

1. Method of compensating for vehicle noise in motor vehicles when playing back useful electrical signals via loudspeakers, the level of the useful signal being adjustable separately in different frequency bands, characterized in that the signals to be played are correlated (5, 6) with reference variables specific to the frequency bands in order to form control signals for adjusting the useful signal level, and in that the useful signal level is adjusted according to the ratio of the signal to be played back in individual frequency bands to reference variables specific to the frequency bands, and the reference variables specific to the frequency bands are derived from the instantaneous velocity of the motor vehicle.

2. Circuit to compensate for vehicle noise using the method according to Claim 1, having a calculation unit (2) for forming reference variables, specific to the frequency bands, from a signal indicating the instantaneous velocity of the motor vehicle, having an equalizer (13) which is connected upstream of the loudspeakers (17) and whose signal inputs can be selectively connected to the output of a radio receiver (7) and, for calibration of a calculation unit (2), via an amplifier (3) for adjusting the equalizer (13) to the output of a noise-signal generator (4), having a first frequency-separating filter (16) in the output of the noise-signal generator (4), whose outputs can be connected via a second change-over switch (15) to the amplifier whose settings are stored in the calculation unit (2) and are correlated with the measurement of a velocity sensor (1), and having a second frequency-separating filter (9) in the output of the radio receiver (7), downstream of which correlators (5, 6) are connected in which the output signals of the second frequency-separating filter are correlated with evaluation variables from the calculation unit (2) for adjusting the equalizer (13).

3. Circuit according to Claim 2, Characterized by a memory in which coefficients which characterize the functional relationship between the velocity and the vehicle noise in the individual bands are stored.

4. Circuit according to Claim 2, characterized in that the correlator (5, 6) in each case calculates the ratios between the envelope curve of the output signals of the second frequency-separating filter (9) and the output signals of the calculation unit (2).

5. Circuit according to Claim 2 or 3, characterized in that a stereo decoder forms the output of the radio receiver (7), and an adder (8) for the two stereo signals is arranged in the input of the second frequency-separating filter (9).

**Revendications**

1. Procédé de couverture du bruit de roulement dans des véhicules automobiles, selon lequel la reproduction des signaux électriques utiles se fait par des haut-parleurs, avec un niveau du signal utile réglable séparément dans différentes bandes de fréquence,
caractérisé en ce que

- les signaux à reproduire sont combinés dans des circuits de corrélation (5, 6) avec des grandeurs de référence spécifiques aux bandes de fréquences, pour former des signaux de réglage servant à régler le niveau du signal utile, et
- le réglage du niveau du signal utile se fait en fonction du rapport du signal à reproduire dans les différentes bandes de fréquences, et des grandeurs de référence spécifiques aux bandes de fréquences, et les grandeurs de référence spécifiques aux bandes de fréquences sont déduites de la vitesse instantanée du véhicule.

2. Circuit pour couvrir le bruit du véhicule, mettant en oeuvre le procédé de la revendication 1, comprenant un calculateur (2) pour former des grandeurs de référence spécifiques à la bande de fréquences à partir d'un signal indiquant la vitesse instantanée du véhicule, un égaliseur (13) en amont des haut-parleurs (17) et dont les entrées de signaux sont reliées, par un premier commutateur (14), au choix à la sortie d'un récepteur radio (7), et pour le tarage du calculateur (2), par un amplificateur (3) pour régler l'égaliseur (13), à la sortie d'un générateur de signal de bruit (4), ainsi qu'un premier aiguillage de fréquence (16) à la sortie du générateur de signal de bruit (4), dont les sorties sont reliées par un second commutateur (15) aux amplificateurs, les valeurs de réglage étant mémorisées dans le calculateur (2) et ces valeurs étant mises en corrélation avec la valeur de mesure d'un capteur de vitesse (1),
ainsi qu'un second aiguillage de fréquences (9) à la sortie du récepteur radio (7), suivi de circuits de corrélation (5, 6) dans lesquels les signaux de sortie du second aiguillage de fréquences sont mis en corrélation avec des grandeurs de pondération du mécanisme de calcul (2) pour régler l'égaliseur (13).

3. Circuit selon la revendication 2,
caractérisé par
une mémoire avec des coefficients caractérisant la relation fonctionnelle entre la vitesse et le bruit de circulation dans les différentes bandes.

4. Circuit selon la revendication 2,
caractérisé en ce que
le circuit de corrélation (5, 6) forme chaque fois le quotient entre la courbe enveloppe des signaux de sortie du second aiguillage de fréquence (9), et le signal de sortie du calculateur (2).

5. Circuit selon les revendications 2 ou 3,
caractérisé par
un décodeur stéréo formant la sortie du récepteur radio (7) et l'entrée du second aiguillage de fréquence (9), comportant un additionneur (8) pour les deux signaux stéréophoniques.

Pegel

Fig. 1

v >

v <

f

Fig. 2